## Europäisches Patentamt

## European Patent Office

## Office européen des brevets

(19)

(11) Veröffentlichungsnummer: **0 162 124**
**A1**

(12) # EUROPÄISCHE PATENTANMELDUNG

(21) Anmeldenummer: **84106483.5**

(22) Anmeldetag: **06.06.84**

(51) Int. Cl.⁴: **H 05 K 3/36**

(30) Priorität: **22.05.84 DE 3418958**

(43) Veröffentlichungstag der Anmeldung:
**27.11.85 Patentblatt 85/48**

(84) Benannte Vertragsstaaten:
**DE FR GB NL**

(71) Anmelder: **NIPPON MEKTRON, LTD.**
**12-15, 1-Chome Shiba Daimon**
**Minato-ku Tokyo(JP)**

(72) Erfinder: **Kameda, Eiichi**
**757, Amaboki Kukuzaki-Mura**
**Inashiki-Gun Ibaraki Pref.(JP)**

(74) Vertreter: **Weissenfeld-Richters, Helga, Dr.**
**Höhnerweg 2**
**D-6940 Weinheim/Bergstrasse(DE)**

(54) **Vorrichtung und Verfahren zum elektrischen und mechanischen Verbinden flexibler gedruckter Schaltfolien.**

(57) Es werden eine Vorrichtung sowie ein Verfahren zum festen elektrischen und mechanischen Verbinden sehr dünner flexibler, einseitig gedruckter Schaltfolien mit gleichartigen oder anderen elektronischen Bauteilen beschrieben, wobei die Vorrichtung aus einem gummielastischen Element (3) besteht, welches über eine Stütz- und Andrückplatte (4) von der Unterseite (2) der flexiblen Leiterfolie her die elektrischen Kontakte (1) und (5) der beiden Bauteile gleichmäßig unverrückbar gegeneinander preßt, wobei der Zusammenhalt mittels Schraub-, Niet-, Schweiß- oder Klebeverbindung gewährleistet ist.

FIG. 2

EP 0 162 124 A1

**Dr. H. Weissenfeld-Richters**

Patentanwältin

Höhnerweg 2-4
694U Weinheim/Bergstr.
Telefon (0.62 01) 80-8618
Telex 4 65 531 **0162124**

4. Juni 1984

Ho/Sch   R 322/Europa

-1-

Anmelderin: Firma Nippon Mektron Ltd., Seiwa Bldg.,
12-15 Shiba Daimon 1-chome Minato-Ku,
Tokyo/Japan

---

## Vorrichtung und Verfahren zum elektrischen und mechanischen Verbinden flexibler gedruckter Schaltfolien

---

Die Erfindung betrifft eine Vorrichtung sowie ein Verfahren zum festen elektrischen und mechanischen Verbinden einer sehr dünnen, nur einseitig mit Leiterbahnen versehenen, flexiblen gedruckten Schaltfolie mit einem gleichartigen oder anderen elektronischen Bauteil.

Zum Stand der Technik gehören bereits zahlreiche
Methoden, flexible gedruckte Schaltfolien leitend miteinander zu verbinden. So wird beispielsweise in DE-PS
20 03 225 vorgeschlagen, die Anschlußenden der Folie
umzuschlagen und miteinander über eine manuell zu betätigende Klemmeinrichtung zu verbinden.

In DE-AS 26 24 666 wird ein nietartiges Kontaktstück
beschrieben, welches die Leiterfolien zusammenhalten
und zugleich elektrisch verbinden soll.

Für die elektrische Verbindung flexibler gedruckter
Schaltfolien mit anderen elektronischen Bauteilen werden
die speziell angeordneten Leiterbahnen-Enden häufig in
einen entsprechenden Stecker eingeklemmt. Dieser – in
sich starre – Stecker wird sodann in die Buchse der
anderen elektronischen Komponente gesteckt.

Bei der Verbindung von flexiblen mit starren Leiterbahnen
ist es ein gebräuchliches Verfahren, eine elastische
Kontaktlasche an der (festen) Leiterplatte im Kontaktbereich vorzusehen. Das Anschlußende der flexiblen
Schaltfolie wird zwischen die Lasche und die feste Leiterplatte gebracht und unter Klemmwirkung die Kontakte
fixiert, ähnlich wie es bereits in DE-PS 20 03 225 aufgezeigt wurde.

Die erwähnten Vorrichtungen und Verfahren versagen jedoch oft, wenn die Innenseiten der Verbindungsstücke
und der Leiterplatten komplexere Formen und Anordnungen
aufweisen; es treten Handhabungs- und Einbauprobleme
auf infolge der übergroßen Starrheit im Anschluß- und
Kontaktbereich.

Schlechte, sich voneinander lösende Kontaktpunkte sind die Folge, insbesondere wenn die Schaltungen häufig Erschütterungen ausgesetzt sind oder in gekrümmter Anordnung in enge Räume eingebaut werden müssen.

Es sind bereits Versuche unternommen worden, ein elastisches Kontaktelement am Anschlußende auch der flexiblen gedruckten Schaltung anzubringen, um so den nötigen Anpreßdruck zu erzielen. Im Falle sehr dünner Elemente mit Dicken um oder kleiner als 2,54 µm (100 µ inch) jedoch erwies sich dieses Anschlußende als nicht fest genug, um mechanischen Belastungen zu widerstehen.

Aufgabe der vorliegenden Erfindung war es daher, die beschriebenen Nachteile zu umgehen und sichere, mechanisch belastbare elektrische Verbindungen zwischen insbesondere sehr dünnen, einseitig mit Leitermaterial versehenen, flexiblen gedruckten Schaltfolien untereinander oder mit anderen elektronischen Bauteilen zu ermöglichen.

Die Lösung dieser Aufgabe besteht erfindungsgemäß in einer Vorrichtung entsprechend dem kennzeichnenden Teil des Anspruchs 1 sowie einem Verfahren zum elektrischen Verbinden der genannten Bauteile mit Hilfe einer solchen Vorrichtung gemäß dem kennzeichnenden Teil des Anspruchs 9.

Ein gegebenenfalls vorgeformtes elastisches Element wird am Anschlußende der flexiblen gedruckten Schaltfolie befestigt, und zwar auf der den Leiterbahnen gegenüberliegenden Seite.

Auf diesem elastischen Element befindet sich eine Stütz-
und Andrückplatte. Mittels einer Schraub-, Niet-,
Schweiß- oder Klebeverbindung entsteht ein unverrückbarer Verbund zwischen Stützplatte, elastischem Element,
flexibler gedruckter Schaltung und dem anzuschließenden zweiten elektronischen Bauteil. Dabei treten infolge
der Flexibilität der Kontaktvorrichtung und des flächig
verteilten Anpreßdruckes weder eine Beschädigung des
Anschlußendes der dünnen Leiterfolie noch eine unerwünschte Starrheit des Kontaktbereiches auf.

Die Erfindung wird anhand der Zeichnungen im folgenden
näher erläutert:

Figur 1   ist ein vergrößerter Querschnitt der erfindungsgemäßen Anschlußvorrichtung.

Figur 2   zeigt in perspektivischer Ansicht die Anschlußvorrichtung von Figur 1 an der Verbindung einer
          flexiblen gedruckten Schaltfolie mit einer
          weiteren Leiterplatte.

Figur 3   stellt, ebenfalls perspektivisch, eine ähnliche
          Anschlußvorrichtung dar, jedoch hier als Verbindung zwischen einer flexiblen gedruckten
          Schaltfolie und einer Steckerleiste.

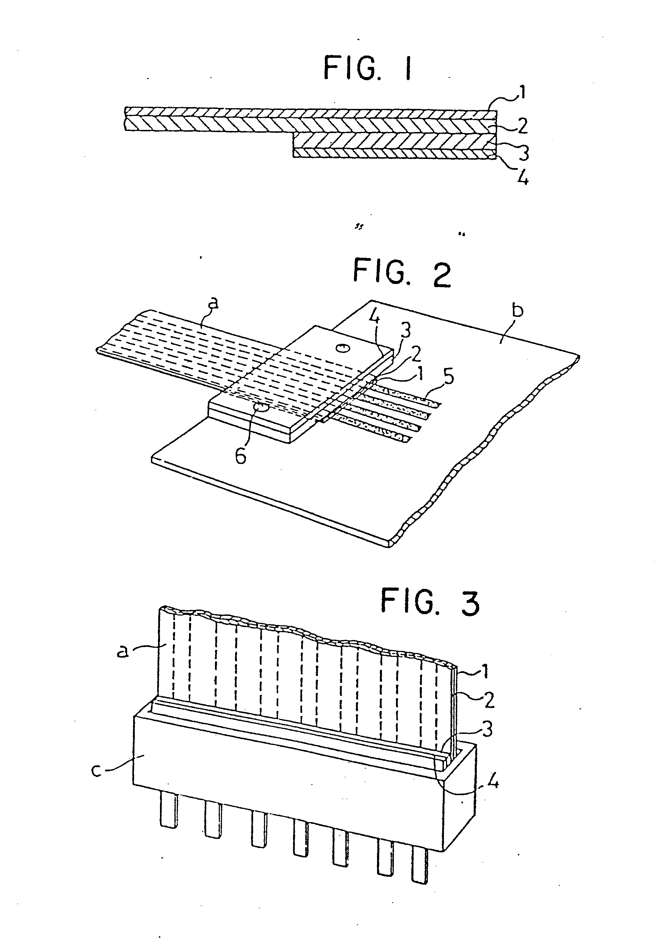

Die erfindungsgemäße Vorrichtung in Figur 1 besteht aus
der Leiterbahn einer gedruckten Schaltung 1, welche
einseitig auf der Basisschicht 2 aufgebracht ist.

Die Leiterbahn 1 ist im allgemeinen ca. 35 µm dick, wohingegen die Klebe- und Basisschicht 2 jeweils ca. 25 µm Stärke aufweisen. In innigem Kontakt mit der den Leiterbahnen gegenüberliegenden Basisfläche 2 befindet sich ein elastisches oder gummielastisches Element 3 mit einer darauf angebrachten Stütz- und Andrückplatte 4. Das elastische Element 3 kann an die Basisschicht 2 und die Platte 4 auf das elastische Element 3 angeklebt sein. Die Platte 4 preßt das elastische Element 3 unverrückbar an die gedruckte Schaltfolie 1 und 2; es besteht dabei eine gleichmäßige Druckverteilung auf die Kontaktflächen der elektrischen Leiter. Die Stützplatte 4 wird im allgemeinen mechanisch mit einer anderen gedruckten Schaltung, z.B. einer festen Platine, verbunden sein.

Das elastische oder gummiartige Element 3 kann aus jedem beliebigen, genügende Elastizität besitzenden Material bestehen, sofern dessen Flexibilität eine sichere Verbindung zuläßt. Als Materialbeispiele seien Silikon-, Urethan-, Natur- oder Neoprenkautschuk und weiches Epoxidharz genannt.

Die Dicke des elastischen Elementes kann je nach der notwendigen Festigkeit verschieden sein; sie liegt gewöhnlich im Bereich von 0,1 bis 0,3 mm. Die Stütz- und Andrückplatte 4 besteht aus einem relativ starren Isolator, z.B. einer Epoxidharzplatte oder mit Phenolharz imprägniertem Papier. Eine Dicke von ca. 0,1 bis 0,3 mm wurde in allen Fällen als ausreichend befunden.

Besondere Formen und Stärken der Elemente 3 und 4 sind nicht erfindungswesentlich, da diese aufgrund ihres einfachen Aufbaues von Fall zu Fall leicht den jeweils miteinander zu verbindenden Komponentenformen beliebig angepaßt werden können, ohne den Rahmen der vorliegenden Erfindung zu verlassen.

Das elastische Element 3 und die Stütz- und Andrückplatte 4 können auf dem jeweiligen Kontaktelement mittels allgemein gebräuchlicher Methoden befestigt werden, so z.B. durch Klebstoffe, Schrauben, Nieten oder Schweißpunkte. Die geeignete Befestigungsart wird im allgemeinen von Faktoren wie Form und Aufbau der Verbindungsteile sowie den Einbauerfordernissen der Schaltelemente bestimmt werden.

In Figur 2 ist der erfindungsgemäße Sandwich-Verbund einer flexiblen, einseitig gedruckten Schaltfolie a mit einer anderen Leiterplatte b gezeigt. Der Leiter 1 der flexiblen Folie a ist dabei unverrückbar mit dem Leiter 5 der starren Leiterplatte b elektrisch verbunden. Diese feste Verbindung wird wiederum durch die Verpressung des elastischen oder gummiartigen Elementes 3 mit der Stütz- und Andrückplatte 4 erreicht, wobei auf die Basisschicht 2 der flexiblen Schaltung a ein starker Anpreßdruck ausgeübt wird. Die Platte 4 wird unter Verwendung von Schrauben, Nieten oder Schweißpunkten 6 in unverrückbaren Kontakt mit dem elastischen Element 3 gebracht, indem die Befestigungselemente zunächst in die entsprechenden Bohrungen der Verstärkungsplatte 4 und danach in die der zweiten Leiterplatte b eingeschraubt bzw. gesteckt werden.

Auf diese Weise wird eine sichere, mechanisch beanspruchbare und dennoch elastische Verbindung des Leiters 1 mit dem Leiter 5 hergestellt.

In Figur 3 ist an die flexible, einseitig gedruckte Schaltung a erfindungsgemäß eine Steckerleiste c angepreßt, wobei analog Figur 2 das elastische Element 3 über die Stütz- und Tragplatte 4 sowie die Basisschicht 2 einen flächig verteilten Anpreßdruck auf den Leiter 1 und die Kontakte der Steckerleiste c ausübt. Die Stützplatte 4 und das elastische Element 3 sind dabei entsprechend der inneren Form des Steckersockels c ausgeformt. Dieser Sockel ist in Form und Flexibilität zweckmäßigerweise für eine elastische mechanische und elektrische Verbindung zwischen dem Leiter 1 und den Leitern in c ausgelegt.

In diesem Beispiel sind Element 3 und Platte 4 mit der Steckerleiste c und der Basisplatte 2 durch einen geeigneten Klebstoff verbunden.

Die Vorteile der erfindungsgemäßen Kontaktvorrichtung bzw. des Verbindungsverfahrens liegen insbesondere darin, daß nun auch extrem dünne, einseitig mit Leiterbahnen versehene, flexible gedruckte Schaltungen unverrückbar, elastisch und zerstörungsfrei miteinander oder mit anderen elektronischen Bauteilen verbunden werden können, da die Stützplatte 4 gleichsam eine Verstärkung der flexiblen Leiterbahnen im Kontaktbereich darstellt und daneben einen flächigen, gleichmäßigen Anpreßdruck für die Kontakte gewährleistet.

Die Biegsamkeit sowie der elastomere Charakter des Anschlußelementes 3 unterstützt diese Eigenschaften dabei
wesentlich. Somit wird die Handhabung biegsamer, dünner
elektronischer Komponenten, besonders beim Ein- bzw. Zusammenbau in bzw. zu größeren Einheiten, wesentlich erleichtert, da ihre mechanische Beanspruchbarkeit trotz
der erhalten gebliebenen Flexibilität des Sandsich-
Kontakt-Verbundes erheblich größer geworden ist und die
Kontakte auch unter verschärften Einsatzbedingungen untrennbar und auf einfache Weise miteinander verbunden
sind.

Bezugszeichenliste

1   Leiterbahn der flexiblen gedruckten Schaltfolie
    (a) im Verbindungsbereich

2   Basisschicht der Schaltfolie (a)

3   Elastisches oder gummiartiges Element

4   Stütz- und Andrückplatte

5   Leiterbahn des zweiten elektronischen Bauteils (b)
    im Verbindungsbereich

6   Schraube, Niet- oder Schweißpunkt

a   flexible, einseitig gedruckte Schaltfolie

b   zweites elektronisches Bauteil (Leiterplatte)

c   Steckerleiste

Ansprüche:

1. Vorrichtung zur elektrischen und mechanischen Verbindung einer dünnen, flexiblen gedruckten Schaltfolie mit einem gleichartigen oder anderen elektronischen Bauteil, wobei die flexible gedruckte Schaltfolie aus einer Basisschicht mit einseitig aufgebrachten elektrischen Leiterbahnen aufgebaut ist, dadurch gekennzeichnet, daß die Vorrichtung besteht aus

a) einem gummielastischen, gegebenenfalls verformten Element (3), welches auf der nicht mit Leiterbahnen (1) versehenen Basisschichtseite (2) aufliegt;

b) einer Stütz- und Andrückplatte (4), welche auf dem elastischen Element (3) aufliegt, und

c) den Sandwich-Verbund zusammenpressenden Befestigungselementen (6).

2. Vorrichtung gemäß Anspruch 1, dadurch gekennzeichnet, daß das elastische Element aus Silikon-, Urethan-, Natur-, Neoprenkautschuk oder weichem Epoxidharz besteht.

3. Vorrichtung gemäß Anspruch 1 oder 2, dadurch gekennzeichnet, daß das elastische Element eine Dicke von 0,1 bis 0,3 mm aufweist.

4. Vorrichtung gemäß den vorhergehenden Ansprüchen, dadurch gekennzeichnet, daß die Stütz- und Andrückplatte aus Epoxidharz besteht.

5. Vorrichtung gemäß den vorhergehenden Ansprüchen, dadurch gekennzeichnet, daß die Stütz- und Andrückplatte aus mit Polymerharz imprägniertem Papier besteht.

6. Vorrichtung gemäß Anspruch 5, dadurch gekennzeichnet, daß die Imprägnierung aus Phenolharz besteht.

7. Vorrichtung gemäß den vorhergehenden Ansprüchen, dadurch gekennzeichnet, daß die Stütz- und Andrückplatte eine Dicke von 0,1 bis 0,3 mm aufweist.

8. Vorrichtung gemäß den vorhergehenden Ansprüchen, dadurch gekennzeichnet, daß die flexible gedruckte Schaltung eine Dicke von maximal 2,54 µm (100 µ inch) besitzt.

9. Vorrichtung gemäß den vorhergehenden Ansprüchen, dadurch gekennzeichnet, daß die Befestigungselemente Schrauben, Nieten oder Schweißpunkte sind.

10. Vorrichtung gemäß den vorhergehenden Ansprüchen, dadurch gekennzeichnet, daß das Befestigungselement ein Klebstoff ist.

11. Verfahren zum elektrischen und mechanischen Verbinden einer dünnen, flexiblen, einseitig gedruckten Schaltfolie mit einem gleichartigen oder anderen elektronischen Bauteil, wobei die flexible Schaltung aus einer Basisschicht mit einseitig darauf aufgebrachten Leiterbahnen besteht, dadurch gekennzeichnet, daß man eine Vorrichtung, bestehend aus

a) einem gummielastischen, gegebenenfalls verformten Element (3), welches auf der nicht mit Leiterbahnen versehenen Seite der Basisschicht (2) aufliegt, und

b) einer Stütz- und Andrückplatte (4), welche auf dem elastischen Element (3) aufliegt,

mit Befestigungselementen (6) so zusammenfügt, daß die Stützplatte (4) an das elastische Element (3) angedrückt und somit gleichzeitig die Kontaktflächen der Leiterbahnen (1) und (5) der beiden elektronischen Bauteile unverrückbar aufeinandergepreßt werden.

12. Verfahren nach Anspruch 11, dadurch gekennzeichnet, daß die Vorrichtung mittels Schrauben, Nieten oder Schweißpunkten zusammengepreßt wird.

13. Verfahren nach Anspruch 11, dadurch gekennzeichnet, daß die Vorrichtung mit Hilfe eines Klebstoffes zusammengepreßt wird.

## FIG. 1

## FIG. 2

## FIG. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (int. Cl 4) |
|---|---|---|---|
| X | DE-B-2 556 596 (FUJI)<br><br>* Anspruch 1; Spalte 2, Zeile 45 - Spalte 4, Zeile 7; Figur * | 1,2,9, 11 | H 05 K 3/36 |
| | --- | | |
| A | US-A-3 985 413 (EVANS)<br>* Spalte 2, Zeile 30 - Spalte 3, Zeile 4; Figuren 1-3 * | 1,2,11 | |
| | ----- | | |

RECHERCHIERTE SACHGEBIETE (Int. Cl.4)

H 01 R 23/70
H 01 R 23/72
H 05 K 1/14
H 05 K 3/30
H 05 K 3/36

Der vorliegende Recherchenbericht wurde für alle Patentansprüche erstellt.

| Recherchenort | Abschlußdatum der Recherche | Prüfer |
|---|---|---|
| BERLIN | 14-08-1985 | HAHN G |